# EUROPEAN PATENT APPLICATION

(11) **EP 2 434 653 A1**
(43) Date of publication of application: **28.03.2012**
(21) Application number: 10777321.0
(22) Date of filing: 21.04.2010
(51) Int. Cl.: H04B 1/38, H04W 88/06

(54) **RADIO TRANSCEIVER FOR MOBILE COMMUNICATION TERMINAL**

(30) Priority: 22.05.2009 CN 200910107483
(71) Applicant: Huizhou Tcl Mobile Communication Co., Ltd, Guangdong 518067 (CN)
(72) Inventor: BAI, Jian, Guangdong 518067 (CN)
(74) Representative: Brachmann, Roland W.
(86) International application number: PCT/CN2010/071987
(87) International publication number: WO 2010/133117

(57) **Abstract**

The invention is applied to mobile communication technique field, and a radio transceiver of a mobile communication terminal is provided. The radio transceiver includes a baseband chip, a radio frequency transceiver, a power amplifier module and an antenna. The radio transceiver also includes a network selecting switch and two or above matching networks, wherein, radio receiving and transmitting performance of the two or above matching networks respectively corresponds to different working modes of the mobile communication terminal; the network selecting switch is used to select one from the two or above matching networks and control the selected matching network to connect with the antenna. The technical solution provided by the invention enables radio performance of the mobile communication terminal optimized in various application circumstances, improves satisfaction of clients, and is also helpful for optimization of the mobile network and increase of the network capacity.

## Description

### Technical Field

The present invention belongs to the field of communication technology, and more specifically, the present invention relates to a wireless receiving and emitting device for mobile communication terminals.

### Background Art

Prior art mobile communication terminals mostly employ built-in antennas, while the environment for built-in antenna applications has become increasingly harsh, which is mainly reflected in the following aspects:
1. Dual-mode and even multi-mode mobile communication terminals are increasingly popular, typically including 3G and GSM dual-mode mobile communication terminals, which require that an antenna works in a number of frequency bands. Under the GSM standard alone, mobile communication terminals have been requested to support a maximum of Quad-band (simultaneously support 4 GSM frequency bands: GSM850/EGSM/DCS/PCS), which has imposed very high multiple frequency and broadband requirements for antennas.
2. Mobile communication terminals become increasingly small, which requires thin and small exterior appearance. Such a design would certainly lead to smaller clearance for antennas, which in turn affects the antenna bandwidth and makes the development significantly more difficult.
3. There are more and more changes to the appearance of mobile communication terminals, such as flip cover and slide cover cell phones. In addition, the external environment that a mobile communication terminal is used in changes frequently, such as talking while holding the phone close to face or via an earphone; when the appearance or application environment of a mobile communication terminal changes, parameters of a built-in antenna will change as well.

Despite of changing and harsh application environments, mobile communication terminals are still required to have excellent performance under various environments. Given the above conditions, it would be very difficult to meet such complex performance demand with only one single antenna matching network, which tends to result in overly long R&D periods and poor performance of mobile communication terminals.

How to improve the wireless performance of a mobile communication terminal through a number of antenna matching networks is a problem that has not been solved by the prior art.

### Disclosure of Invention

### Technical Problem

The object of the present invention is to provide a wireless receiving and emitting device for mobile communication terminals so as to solve the issue of optimizing wireless receiving and emitting performance of mobile communication terminals.

### Technical Solution

The present invention is realized in the following manner: a wireless receiving and emitting device for mobile communication terminals, comprising a baseband chip, a radio frequency (RF) transceiver, a power amplification (PA) module and an antenna; said wireless receiving and emitting device further comprises a network selection switch and two or more matching networks, wherein:
- The wireless receiving and emitting performance indexes of said two or more matching networks correspond to different working modes of the mobile communication terminal, respectively;
- Said network selection switch is used for selecting one out of said two or more matching networks and the selected matching network is controlled to be communicated with said antenna.

Said matching networks comprise inductors and capacitors, and inductors and capacitors in different matching networks have different performance indexes.

Said network selection switch is connected to said baseband chip, and according to a working mode of the mobile communication terminal, said baseband chip is used to control said network selection switch to select one out of said two or more matching networks that corresponds to said working mode.

Said mobile communication terminal is a flip cover mobile communication terminal, and according to the channel range in which said mobile communication terminal works, said baseband chip is used to control said network selection switch to select one out of said two or more matching networks that corresponds to the channel range in which said mobile communication terminal works.

Said mobile communication terminal is a multi-mode mobile communication terminal, and according to a working standard of said mobile communication terminal, said baseband chip is used to control said network selection switch to select one out of said two or more matching networks that corresponds to the working standard of said mobile communication terminal.

Said mobile communication terminal is a mobile communication terminal equipped with a PIFA antenna, and according to the frequency band in which said mobile communication terminal works, said baseband chip is used to control said network selection switch to select one out of said two or more matching networks that corresponds to the frequency band in which said mobile communication terminal works.

### Advantageous Effects:

The present invention overcomes drawbacks of the prior art by configuring two or more matching networks to a mobile communication terminal. The mobile communication terminal can select one matching network therefrom according to its working conditions that matches the antenna, thereby optimizing its wireless receiving and emitting performance. The technical solution provided herein leads to optimized wireless performance of the mobile communication terminal under various application environments, improves client satisfaction, and is also helpful for optimizing the mobile network and improving the network capability.

### Brief Description of Drawings

- Fig.1: is a system block diagram of the wireless receiving and emitting device for mobile communication terminals provided in an embodiment of the present invention;
- Fig.2: is a flow chart of an embodiment of the present invention.

### Best Mode for Carrying Out the Invention

To make the object, technical solution and advantages of the present invention clearer, the present invention is further described in detail below with reference to the accompanying drawings and embodiments. It should be understood that the embodiments described herein are used only to describe the present invention with no intention to limit the present invention in any way.

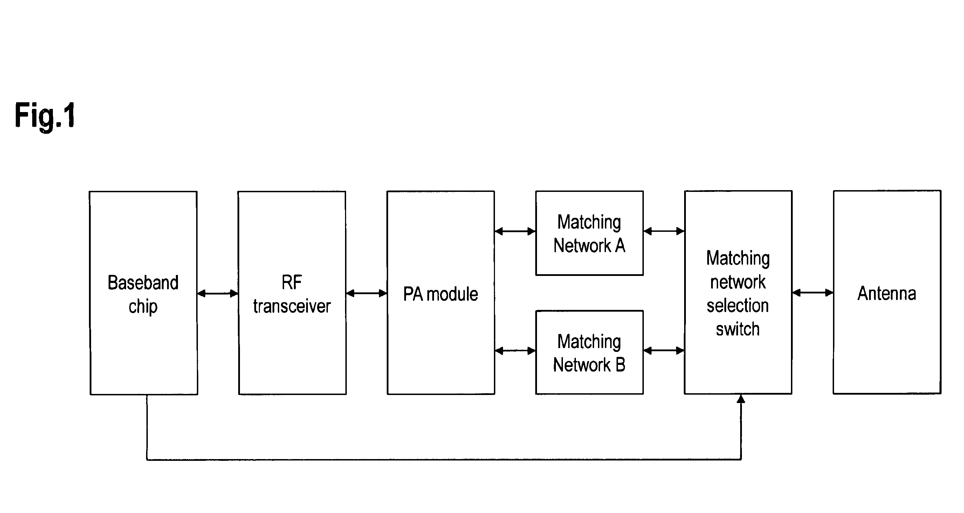

The system block diagram of a wireless receiving and emitting device for mobile communication terminals provided in the embodiment of the present invention is shown in **Fig.1****,** which comprises a baseband chip, a RF transceiver, a PA module, an antenna, two or more matching networks (for example, Matching Network A and Matching Network B in Fig.1), and a matching network selection switch, wherein, the baseband chip is connected to the RF transceiver via a data line and a control line, the RF transceiver is connected to the PA module via a RF transmission line, the PA module is connected to Matching Network A and Matching Network B, Matching Network A and Matching Network B are connected to the matching network selection switch, the matching network selection switch is connected to the antenna, and the baseband chip is further connected to the matching network selection switch.

According to a working mode of the mobile communication terminal, such as current working standard, frequency point, appearance and application environment, the baseband chip is used to control the matching network selection switch, and according to the control by the baseband chip, the matching network selection switch is used to select Matching Network A to communicate with the antenna or to select Matching Network B to communicate with the antenna. A high frequency switch can be used as the matching network selection switch that is controlled by the GPIO (General Purpose Input/ Output) of the baseband chip.

When a mobile communication terminal transmits a signal, the baseband chip encodes and modulates audio and data information collected or generated by the mobile communication terminal, and thereby a baseband modulation signal S¬B is obtained. The baseband chip transmits the S¬B to the RF transceiver via the data line, and the RF transceiver up converts the baseband modulation signal to a RF signal SRF. The RF transceiver transmits the RF signal SRF to the PA module via the RF transmission line. According to the current working standard, frequency point, appearance and application environment of the mobile communication terminal, the baseband chip controls the matching network selection switch, and according to the control by the baseband chip, the matching network selection switch is used to select Matching Network A to communicate with the antenna or to select Matching Network B to communicate with the antenna. When Matching Network A or Matching Network B communicates with the antenna, the PA module amplifies SRF and transmits to the antenna via Matching Network A or Matching Network B, and the antenna ultimately transmits the same out.

When a mobile communication terminal receives a signal, according to the current working standard, frequency point, appearance and application environment of the mobile communication terminal, the baseband chip controls the matching network selection switch, and according to the control by the baseband chip, the matching network selection switch is used to select Matching Network A to communicate with the antenna or to select Matching Network B to communicate with the antenna. When Matching Network A or Matching Network B communicates with the antenna, the antenna receives the external RF signal SRF via Matching Network A or Matching Network B, which is amplified by the PA module and transmitted to the RF transceiver. The RF transceiver down converts the RF signal SRF to a baseband modulation signal S¬B and transmits to the baseband chip. The baseband chip demodulates and decodes the same to obtain audio or digital information.

Wherein, Matching Network A and Matching Network B are consisted of discrete components (typically high frequency inductors and high frequency capacitors). Different matching networks have different performance parameters for discrete components thereof, and different matching networks correspond to different working frequency ranges. Namely, the working frequency of a mobile communication terminal is divided into several different frequency bands with each frequency band designed with a corresponding matching network. It is well known that it is easier to adjust a matching network and to achieve better performance indexes thereof when its working frequency range is smaller. Therefore, the mobile communication network can consider different situations by selecting a matching network corresponding to the working frequency range such that when a RF signal within the working frequency band is transmitted between the antenna and the PA module and between the antenna and the baseband chip, its loss is minimized, and thereby the wireless performance of the mobile communication terminal is optimized.

In specific applications of the technology provided by the present invention, Matching Network A and Matching Network B may also be designed as a circuit comprising a set of discrete components with the performance index of each discrete component adjustable. When the performance index of each discrete component is adjusted to the A working mode, it corresponds to Matching Network A as described herein, and when the performance index of each discrete component is adjusted to the B working mode, it corresponds to Matching Network B as described herein.

In specific embodiments of the technology provided by the present invention, according to specific situations in the process of developing a mobile communication terminal, the number of matching networks is selected, a working frequency range is assigned to each matching network, and different matching networks are designed according to the selected working frequency ranges. Specific applications of the technology provided by the present invention include but are not limited to the following cases:
1. For a flip cover mobile communication terminal with relatively short main board, at low frequencies, the small main board size results in a reduced main ground length, which subsequently affects the antenna's bandwidth at low frequencies. When the cover is closed, it will be relatively difficult to satisfy the bandwidth at low frequencies. In such a circumstance, two matching networks can be used to carry out wireless receiving and emitting tasks. Through different matching networks, the antenna is adjusted to work in different channel intervals at low frequencies, for example, channels of low frequency GSM850 are numbered from channel 128 to channel 251 with a total of 124 channels covering a 25 MHz bandwidth. For the above case of relatively short main ground length, a single matching network would be difficult to cover a bandwidth of 25 MHz. Two matching networks (Matching Network A and Matching Network B) can be designed. Adjust Matching Network A to work with the antenna such that the antenna has the optimal performance in channel 128 to channel 190, and adjust Matching Network B such that the antenna has the optimal performance in channel 191 to channel 251. In practical applications, if a mobile communication terminal works in a high channel interval (channel 191 to channel 251), then the baseband chip controls Matching Network B to communicate with the antenna via a matching network selection switch; if the mobile communication terminal works in a low channel interval (channel 128 to channel 190), then the baseband chip controls Matching Network A to communicate with the antenna via the matching network selection switch. Regardless of which channel the mobile communication terminal works in, optimal radiation performance can be obtained in the end. Through the above design, the working range of each matching network is reduced from 25 MHz to 12.5 MHz, which greatly reduces the design difficulty and enables terminals of relatively short lengths to obtain excellent radiation performance as well. In such a way, the entire low frequency bandwidth can be covered and at the same time, the requirement for PCB length can be lowered correspondingly as well. As a result, the flip cover mobile communication terminal can be designed to be relatively small and short.
2. For a multi-mode mobile communication terminal, different matching networks can be designed according to different working standards. When the mobile communication terminal works under different standards, different matching networks are selected to match the antenna, and then the antenna's performance parameters, such as return loss and VSWR, can all reach optimal values. For a dual-mode terminal of WCDMA Band I (working frequency band at 2.1 GHz) and GSM (working frequency band at 850MHz/900MHz/1800/1900MHz), for example, it would be difficult to use only one matching network to cover 5 frequency bands. During design, two matching networks (Matching Network A and Matching Network B) can be selected. Adjust Matching Network A to work with the antenna such that the antenna has the optimal radiation performance at 1800/1900/2100MHz, and adjust Matching Network B to work with the antenna such that the antenna has the optimal radiation performance at 850/900MHz. In practical applications, if a mobile communication terminal works in a high frequency band (2100MHz or 1800Mhz or 1900MHz), then Matching Network A can be controlled via a network selection switch to communicate with the antenna; if the mobile communication terminal works in a low frequency band (850MHz/900MHz), then Matching Network B can be controlled via a network selection switch to communicate with the antenna. Regardless of which frequency band the mobile communication terminal works in, optimal radiation performance can be obtained. As a result, optimal wireless performance can be obtained under different standards.
3. For a mobile communication terminal equipped with a PIFA (Planar Inverted F Antenna) that does not have sufficient height, the antenna's working parameters can be adjusted by adjusting matching networks. When the mobile communication terminal works in different frequency bands, different matching networks are selected to match the antenna, and then the antenna's performance parameters, such as return loss and VSWR, can all reach optimal values. For example, channels of high frequency DCS 1800MHz (digital cell system 1800MHz) are from channel 512 to channel 885 with a total of 374 channels covering a bandwidth of 75 MHz. For the PIFA antenna with insufficient height (typically seen in very thin terminals), the bandwidth is relatively narrow, and a single matching network would be difficult to cover the entire 75 MHz bandwidth. Therefore, two matching networks (Matching Network A and Matching Network B) can be designed. Adjust Matching Network A to work with the antenna such that the antenna has the optimal performance in channel 512 to channel 698, and adjust Matching Network B such that the antenna has the optimal performance in channel 699 to channel 885. In practical applications, if a mobile communication terminal works in a low channel interval (channel 512 to channel 698), then Matching Network A is controlled to communicate with the antenna via a matching network selection switch; if the mobile communication terminal works in a high channel interval (channel 699 to channel 885), then Matching Network B is controlled to communicate with the antenna via the matching network selection switch. Regardless of which channel the terminal works in, optimal radiation performance can be obtained. Through the above design, the working range of each matching network is reduced from 75 MHz to 37.5 MHz, which greatly reduces the design difficulty and through the above design, excellent radiation performance can be obtained in all channels even when the terminal does not have a sufficient PIFA antenna height.

In some circumstances, if a frequency point in the current zone requires Matching Network A, while the working band of a neighboring zone is within a working frequency range of Matching Network B, information detection for neighboring zones at this time cannot be completed just through Matching Network A. On the contrary, matching networks should be switched in turn during zone detection time slots or within detection channels so as to perform an optimal search of neighboring zones and handover.

In the present invention, the mobile communication terminal can be of a GSM standard, or 3G or other standards, and may even be a multi-mode mobile communication terminal. Matching networks can be two or more.

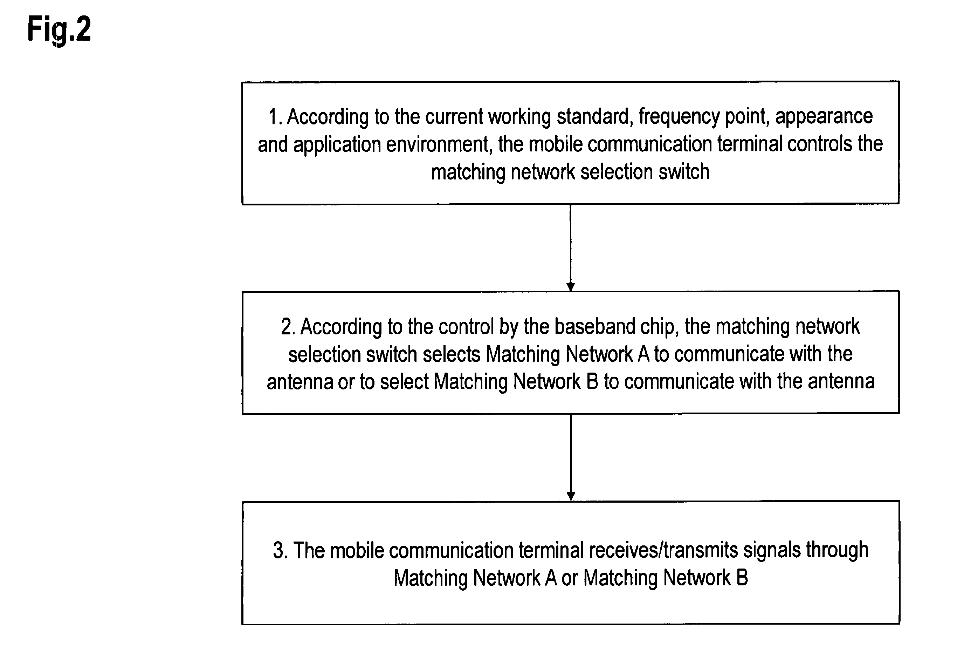

The flow chart of an embodiment of the present invention is shown in Fig.2, specifically comprising the following steps:
1. According to the current working standard, frequency point, appearance and application environment, the mobile communication terminal controls the matching network selection switch;
2. According to the control by the baseband chip, the matching network selection switch selects Matching Network A to communicate with the antenna or to select Matching Network B to communicate with the antenna;
3. The mobile communication terminal receives/transmits signals through Matching Network A or Matching Network B.

Only preferred embodiments of the present invention are described above with no intention to limit the present invention. Any modification, equivalent replacement and improvement made within the spirit and principle of the present invention shall be encompassed in the scope defined by claims herein.

### Mode for Carrying Out the Invention

### Industrial Applicability

Sequence Listing Free Text

## Claims

1. A wireless receiving and emitting device for mobile communication terminals, comprising a baseband chip, a RF transceiver, a PA module and an antenna, **characterized in that** said wireless receiving and emitting device further comprises a network selection switch and two or more matching networks, wherein:
- The wireless receiving and emitting performance indexes of said two or more matching networks correspond to different working modes of the mobile communication terminal, respectively;
- Said network selection switch is used for selecting one out of said two or more matching networks and the selected matching network is controlled to be communicated with said antenna.

2. The wireless receiving and emitting device as set forth in Claim 1, **characterized in that** said matching networks comprise inductors and capacitors, and inductors and capacitors in different matching networks have different performance indexes.

3. The wireless receiving and emitting device as set forth in Claim 1, **characterized in that** said network selection switch is connected to said baseband chip, and according to a working mode of the mobile communication terminal, said baseband chip is used to control said network selection switch to select one out of said two or more matching networks that corresponds to said working mode.

4. The wireless receiving and emitting device as set forth in Claim 3, **characterized in that** said mobile communication terminal is a flip cover mobile communication terminal, and according to the channel range in which said mobile communication terminal works, said baseband chip is used to control said network selection switch to select one out of said two or more matching networks that corresponds to the channel range in which said mobile communication terminal works.

5. The wireless receiving and emitting device as set forth in Claim 3, **characterized in that** said mobile communication terminal is a multi-mode mobile communication terminal, and according to a working standard of said mobile communication terminal, said baseband chip is used to control said network selection switch to select one out of said two or more matching networks that corresponds to the working standard of said mobile communication terminal.

6. The wireless receiving and emitting device as set forth in Claim 3, **characterized in that** said mobile communication terminal is a mobile communication terminal equipped with a PIFA antenna, and according to the frequency band in which said mobile communication terminal works, said baseband chip is used to control said network selection switch to select one out of said two or more matching networks that corresponds to the frequency band in which said mobile communication terminal works.
